# EUROPEAN PATENT SPECIFICATION

(11) **EP 1 076 241 B1**
(45) Date of publication and mention of the grant of the patent: **30.11.2005**
(21) Application number: 00117231.1
(22) Date of filing: 11.08.2000
(51) Int. Cl.: G01R 31/00, G01R 31/317, G06F 11/00, G06F 15/78

(54) **Engine control device**
Steuereinrichtung für eine Brennkraftmaschine
Dispositif de régulation de moteur à combustion interne

(30) Priority: 12.08.1999 JP 22844499
(43) Date of publication of application: 14.02.2001
(73) Proprietor: Hitachi, Ltd., Tokyo 100-8280 (JP); Hitachi Car Engineering Co., Ltd., Hitachinaka-shi, Ibaraki 312-0062 (JP)
(72) Inventor: Miyashita, Kimio, Ibaraki 312-0063 (JP); Nakatsuru, Kunito, Ibaraki 310-0844 (JP); Zaitsu, Masahiro, Ibaraki 312-0032 (JP); Ono, Koichi, Ibaraki 311-0105 (JP)
(74) Representative: Beetz & Partner

(56) References cited:
- US-A- 5 825 193
- PATENT ABSTRACTS OF JAPAN vol. 1998, no. 03, 27 February 1998 (1998-02-27) -& JP 09 304481 A (NISSAN MOTOR CO LTD), 28 November 1997 (1997-11-28)
- PATENT ABSTRACTS OF JAPAN vol. 1996, no. 02, 29 February 1996 (1996-02-29) -& JP 07 287603 A (HITACHI LTD;OTHERS: 01), 31 October 1995 (1995-10-31)

## Description

### BACKGROUND OF THE INVENTION

The present invention relates to an engine control device, and especially relates to an engine control device for screening an integrated circuit that is implemented on a circuit board.

Conventionally in a semiconductor integrated circuit for an engine control device of a vehicle, a chip which is cut out from a wafer is screened after having been protected by a package, and after the initial failure that is a latent defect is removed from the integrated circuit, the chip is implemented in a circuit board.

In the semiconductor integrated circuit of late years, the integrated circuit is mounted on a circuit board in a bare chip state without using the package in order to reduce mounting size or area, to improve electrical characteristics, and to achieve reduction of manufacturing cost.

In this case, it is not effective, as a lot of time is needed, to individually screen the integrated circuit which is in the bare chip state before mounting it on the circuit board, and it is expected to screen the integrated circuit after mounting it.

In the conventional equipment which screens the integrated circuit of the bare chip state on the circuit board, a voltage regulator is provided in the circuit board. When the voltage change over signal is output by a communication signal from an outside communications means, the voltage occurring in the resistor is amplified to be a high voltage (burn-in voltage) by an amplifier circuitry, and the screening is performed by adding said high voltage in said integrated circuit (for example, Japanese Patent Laid-open No. 09-304481 and 10-009041 are referred to).

By the way, in Japanese Patent Laid-open No. 09-304481 bulletin, it is disclosed to screen by adding a burn-in voltage on the integrated circuit after mounting it, wherein the conventional equipment needs a voltage supervisory circuit and a communications means other than a voltage regulator having a resistor, an amplifier, etc. and the constitution thereof becomes to be complicated, and any particular care-and-attention is not done relating to reduction of manufacturing cost by diminution of material number of items and number of production process as a characteristic feature in a case to mount on the circuit board by the bare chip state.

Furthermore, in a technique disclosed in Japanese Patent Laid-open No. 10-009041 bulletin, although any communications means from external is not needed, constitution of said voltage regulator and said voltage supervisory circuit are the same. Japanese Patent Laid-open No. 09-304481 bulletin does not disclose anything relating to the reduction of the manufacturing cost.

JP-A-09304481 discloses an engine controls device comprising an integrated circuit and an output voltage adjustment circuitry to switch a rated voltage to screen the integrated circuit. The output voltage adjustment circuitry comprises plural resistors provided between an output side power line of the rated voltage and the ground side. All components required for checking the integrated circuit in the test mode are within the engine control device which becomes complex, heavy, and costly.

### SUMMARY OF THE INVENTION

The present invention is invented referring to such subject stated above, and an object of the present invention is to provide an engine control device having a voltage adjustment circuitry for screening a semiconductor integrated circuit mounted on a circuit board in a bare chip state so as to reduce a mounting area thereof, improve electric characteristics and reduce manufacturing cost by planning a simple constitution.

In order to achieve the above stated object, an engine control device in the present invention is characterized by comprising an integrated circuit basically such as an arithmetic processing unit etc. for processing operation of control programs, and an output voltage adjustment circuitry to switch a rated voltage to screen said integrated circuit, wherein said output voltage adjustment circuitry comprises plural resistors provided between an output side power line of said rated voltage and a ground side and another resistor coupled to a connecting point between said plural resistors and said ground side is provided outside of said engine control device and inside of a check equipment coupled to said engine control device.

Furthermore, said engine control device may add a higher voltage value than that in usual operation to said integrated circuit when screening said integrated circuit, and said output voltage adjustment circuitry is connected to another resistor connected to said ground side, and a connecting point between said plural resistors is connected to said other resistor and is connected to said constant voltage source circuitry which outputs said rated voltage to said integrated circuit.

As the engine control device of the present invention is constituted as stated above, comprising the output voltage adjustment circuitry to switch the rated voltage to screen the integrated circuit, said output voltage adjustment circuitry being constituted with three resistors at least, all integrated circuits can be screened after being mounted by a low cost constitution without constituting a complicated circuitry, and it becomes possible to reduce manufacturing cost and to save time of screening.

Furthermore, a concrete aspect of the engine control device in the present invention, is characterized in that the other resistor is connected with the ground side by an on/off-switch.

Furthermore, the concrete aspect of the engine control device in the present invention is characterized in that said other resistor is provided external of said engine control device, or is connected to a connecting point between said plural resistors through a non-used terminal of said engine control device.

Furthermore, a concrete aspect of the engine control device is characterized in that said arithmetic processing unit has a memory device to be capable of rewriting said control program by a serial communication signal so as to switch on/off, or said arithmetic processing unit has a control program to switch said rated voltage by said serial communication signal so as to switch on/off.

In the engine control device constituted as above, as the program is rewritten with the serial communication signal or is constituted to be switched, all integrated circuits, after being mounted, can be screened in a case that any non-used terminal is not provided.

Furthermore, the control device in the present invention is characterized by comprising an integrated circuit such as an arithmetic processing unit etc. for processing operation of control programs, an output voltage adjustment means to switch a rated voltage to screen said integrated circuit, and a check means to examine a characteristic of said arithmetic processing unit and said integrated circuit.

### BRIEF DESCRIPTION OF THE DRAWINGS

Figure 1 is a block diagram of the engine control device of the first embodiment configuration of the present invention.
Figure 2 is a block diagram of an engine control device.
Figure 3 is a block diagram of an engine control device.
Figure 4 is a timing chart which explains operating of the engine control device shown in Figure 3.

### DETAILED DESCRIPTION OF THE PREFERRED EMBODIMENT

Embodiment configurations of the engine control device of the present invention will be explained in detail using Figures as follows.

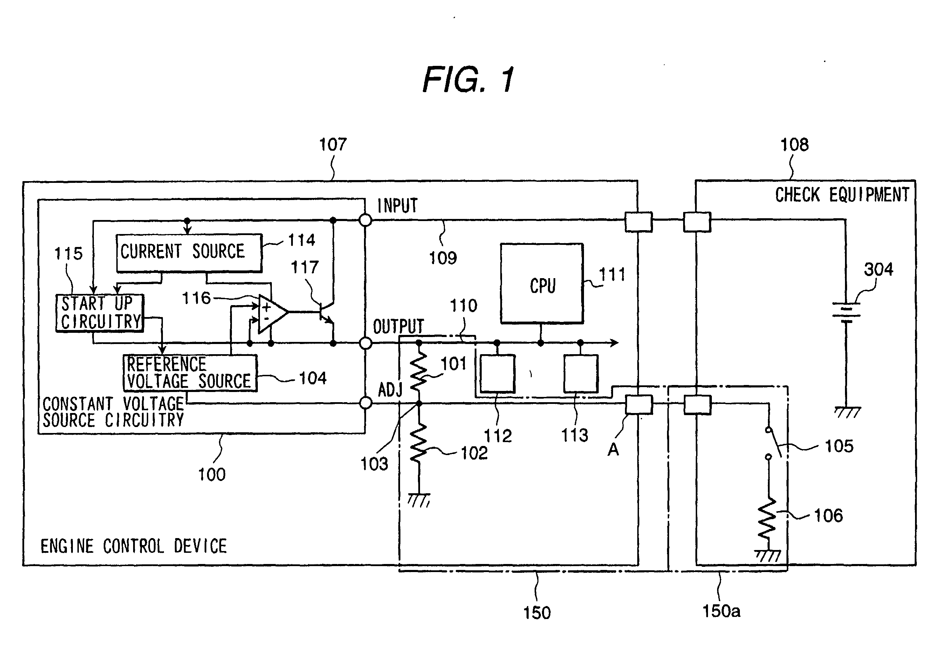

Figure 1 is a block diagram to show a first embodiment configuration of the engine control device.

An engine control device 107 is constituted with a constant voltage source circuitry 100, an arithmetic processing unit (CPU) 111, and an integrated circuit (IC) 112, 113 etc. such as the CPU etc. The CPU 111 and the integrated circuit 112, 113 are mounted on a circuit board in the bare chip state.

Furthermore, the engine control device 107 takes in a signal from a crank angle sensor (illustration is omitted) and detects signals from other various sensors (illustration is omitted), and processes based on detecting signals, so as to output a driving signal to fuel injection valves (illustration is omitted) and to output an ignition driving signal to a spark plug (illustration is omitted). The engine control device 107 is constructed with an input circuit (illustration is omitted), an AD conversion part (illustration is omitted), a storage device ROM (illustration is omitted), and an output circuit (illustration is omitted). The input circuit takes in an input signal (for example, signals from a coolant temperature sensor, a crank angle sensor, and an air fuel ratio sensor etc.) and removes noise components from the input signal so as to supply the input signal to an AD conversion part. The AD conversion part converts the input signal and outputs it to the CPU 111. The CPU 111 takes in the signal converted by the AD conversion. and executes a predetermined control program stored in the ROM, thereby it has a function to execute control of the device. Further, the operation result and the AD conversion result are stored temporarily in the RAM and the operation result of is output as a control output signal through the output circuit so as to be used to control the fuel injection valves.

Furthermore, the engine control device 107 is connected with a check equipment (a screening equipment) 108 through a connector in order to screen the CPU 111 and the integrated circuits 112, 113, and after having screened the integrated circuits 112, 113, characteristics of the CPU 111 and the integrated circuits 112, 113 are checked so as to distinguish good or bad thereof. Then, after being separated from the check instrument 108, only a good device is adopted to an actual machine as engine control device 107.

The check instrument 108 is capable of supplying the battery voltage 304 to a constant voltage source circuitry 100 of the engine control device 107 through an input side power line 109. The constant voltage source circuitry 100 is connected with an output voltage adjustment circuitry 150, and the output voltage adjustment circuitry 150 switches the rated voltage so as to screen the integrated circuits 112, 113.

The constant voltage source circuitry 100 is a variable output type one and constructed with a current source 114, a reference voltage source 104, a start up circuitry 115, an error amplifier 116, and a transistor 117, and outputs a constant rated voltage (for example, 5V) to the CPU 111 and the integrated circuits 112,113 through the output side power line 110.

The output voltage adjustment circuitry 150 switches said rated voltage as stated above so as to screen the CPU 111 and the integrated circuits 112, 113 and is constructed with resistors 101,102,106 and an electric switch 105, and the resistor 101 and the resistor 102 are connected in series between the output side power line 110 of the rated voltage and the ground side. On the other hand, the other resistor 106 to be different from the resistors 101, 102 is provided in another output voltage adjustment circuitry 150a inside of the check equipment 108, one end thereof is connected to the ground side through the electric switch 105, and another end thereof is connected with a connecting point 103 between the resistors 101, 102, and it is connected with the resistor 102 in parallel by turning the electric switch 105 on.

In addition, the other resistor 106 is connected with the connecting point 103 between the resistors 101, 102 through a non-used terminal of the engine control device 107, and is simultaneously connected with a reference voltage source 104 of the constant voltage source circuitry 100.

The screening of the CPU 111 and the integrated circuits 112, 113 is performed as follows.

At first, the battery voltage 304 is supplied to the engine control device 107 by the check equipment 108 through the input side power line 109, and the constant voltage source circuitry 100 supplies a source voltage of the usual constant rated voltage (for example, 5V) to the CPU 111 and the integrated circuits 112, 113 through the output side power line 110, thereby the CPU 111 and the integrated circuits 112, 113 start to operate.

The voltage value of the connecting point 103 in a usual time (intermediate voltage value) is determined according to a ratio of the resistor 101 and the resistor 102 connected in series, and the constant rated voltage is maintained by comparing the intermediate voltage value with a voltage value of the reference voltage source 104 with the error amplifier 116.

Otherwise, when screening, the voltage value of the connecting point 103 (intermediate voltage value) is determined to be switched according to a ratio of the resistors 102 and 106 connected in parallel and the resistor 101 connected therewith in series, by turning the electric switch 105 of the output voltage adjustment circuitry 150, and a voltage value which is higher than that in the usual time is supplied to the CPU 111 and the integrated circuit 112, 113 through the output side power line 110 so as to screen them.

After finishing the screening, the electric switch 105 is turned off, and the characteristic of the device is tested with the check equipment 108 after a predetermined time from the finishing. Then the initial failures being a potential defect of the CPU 111 and the integrated circuit 112, 113 are removed by checking the function of the engine control device 107.

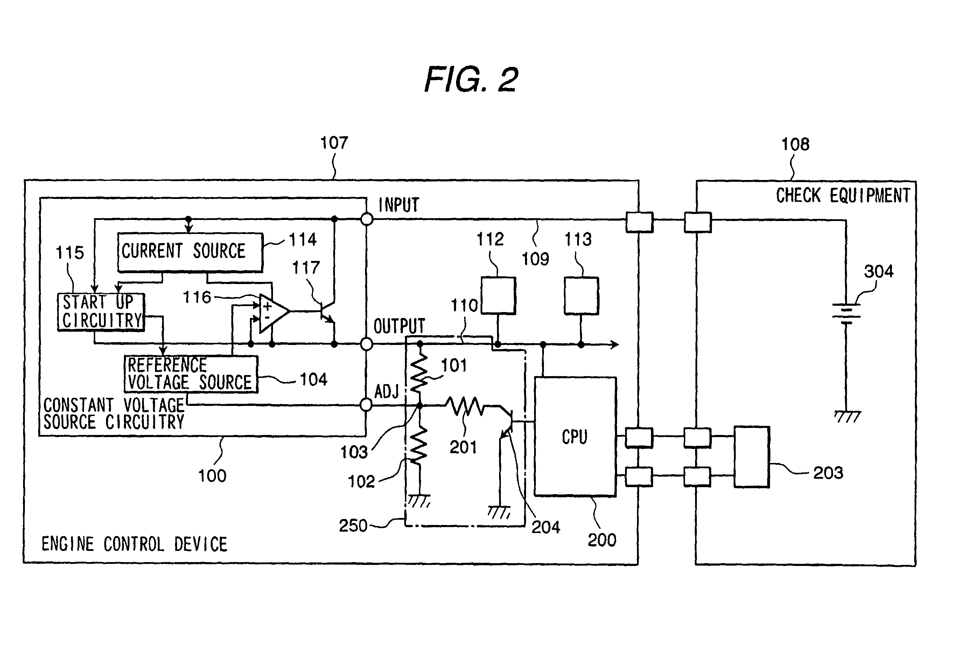

Figure 2 is a block diagram which shows a second configuration of the engine control device, and as Figure 2 shows the same construction as Figure 1 besides a CPU 200 and an output voltage adjustment circuitry 250, only the CPU 200 and the output voltage adjustment circuitry 250 will be explained in detail.

Said CPU 200 has a built-in ROM (a flash ROM) which is capable of rewriting the control program and controls the intermediate voltage of the connecting point 103 by the rewritten control program. The output voltage adjustment circuitry 250 is used to switch the rated voltage in order to screen the integrated circuit 112,113 and is constructed with the resistors 101, 102, 201 and the transistor 204. The resistor 101 and the resistor 102 are connected in series between the output side power line 110 of the rated voltage and the ground side. On the other hand, the other resistor 201 to be different from the resistors 101, 102 is provided inside of the engine control device 107. One end thereof is connected to the ground side through the transistor 204 and another end thereof is connected with the connecting point 103 between the resistors 101, 102. The other resistor 201 is connected with the resistor 102 in parallel by turning the electric switch 204 on.

In addition, in an outside of the engine control device 107, a serial communication means 203 is arranged, and the CPU 200 is switched into a write mode by transmitting the output signal and the control program from the serial communication means 203, and simultaneously the control program of the flash ROM in the CPU 200 is rewritten.

In the usual time, by using the serial communication means 203, a program to set the output of a port 202 of the CPU 200 to be a low level is written in the flash ROM, the transistor 204 is turned off.

The intermediate voltage value is determined according to a ratio of the resistors 101 and 102 connected in series.

On the other hand, when screening, a program to set the output of the port 202 of the CPU 200 to be a high level is written in the flash ROM to be rewritten by the serial communication means 203, and the serial communication means 203 turns on the transistor 204 and determines the voltage value of the connecting point 103 (intermediate voltage value) so as to switch it based on a ratio of the resistors 102 and 201 connected in parallel and the resistor 101 connected in series therewith. The voltage value which is higher than that in the usual time is supplied to the CPU 200 and the integrated circuit 112, 113 through the output side power line 110 so as to screen thereof.

After finishing the screening, the program to set the output of the port 202 to be low level again is rewritten on the flash ROM by the serial communication means 203, thereby the transistor 204 is turned off and characteristics of the device are checked with the check equipment 108 after a predetermined time has passed. Then the initial failures being a potential defect of the CPU 200 and the integrated circuit 112, 113 are removed by checking the function of the engine control device 107.

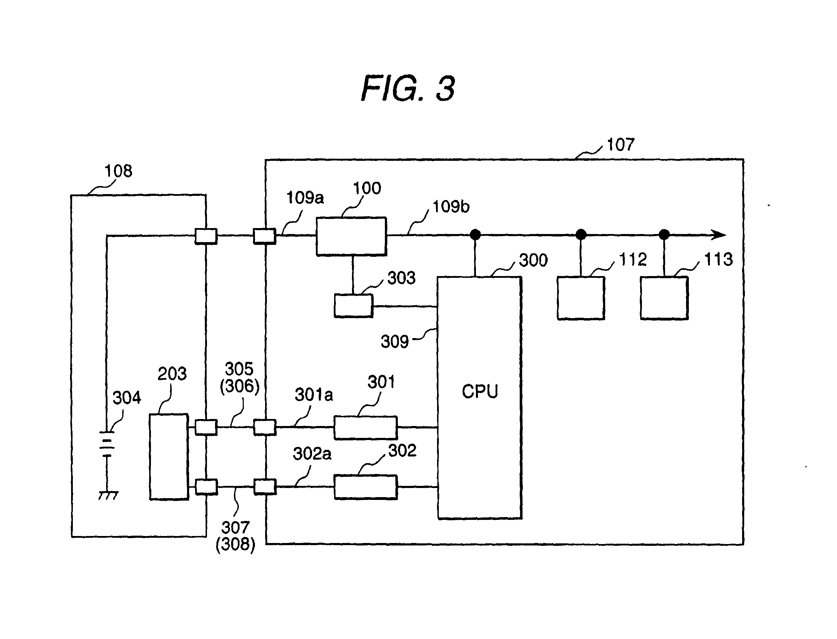

Figure 3 is a block diagram which shows a third configuration of the engine control device, and as Figure 3 shows the same construction as Figure 2 besides a CPU 300, only the CPU 300 will be explained in detail.

The CPU 300 has a built-in control program to switch a program to set the output of the port 309 to be the low level and a program to set the output of the port 309 to be the high level mutually so as to control the intermediate voltage of the connecting point 103.

The output voltage adjustment circuitry 303 is constituted in the same way as output voltage adjustment circuitry 250 shown in Figure 2, has the resistor 101, 102 and 201 and the transistor 204, and switches the rated voltage in order to screen the integrated circuits 112, 113.

The resistors 101 and 102 are connected in series between the output side power line 109b of the rated voltage and the ground side. The one end of the other resistor 201 is connected to the ground side through the transistor 204, and the other end of the resistor 201 is connected with the connecting point 103 between the resistors 101, 102, and is connected with the resistor 102 in parallel by turning the transistor 204 on.

In the usual time, a program to set the output of the port 309 of the CPU 300 to be the low level is designated by the serial communication means 203 so as to turn the transistor 204 off. When performing the screening, a program to set the output of the port 309 of the CPU 300 to be the high level is designated by the serial communication means 203 so as to turn the transistor 204 on, and the voltage value which is higher than that in the usual time is supplied to the CPU 300 and the integrated circuits 112, 113 through the output side power line 109b so as to screen them. After the screening is completed, the program to set the output of the port 309 to be the low level is designated, the transistor 204 is turned off, and after the predetermined time has passed, the characteristic of the device is checked by the check equipment 108. Then the initial failures being a potential defect of the integrated circuits 112, 113 are removed by checking the function of the engine control device 107.

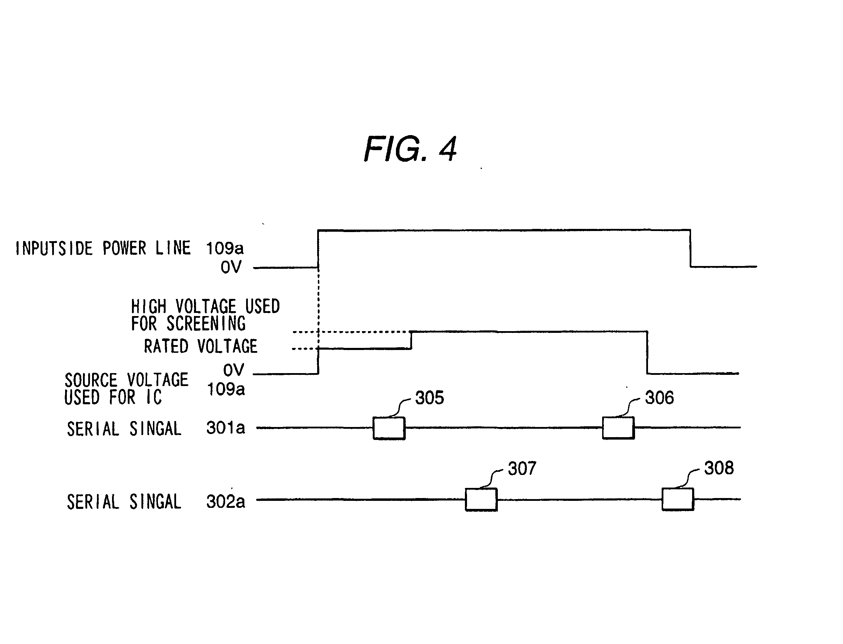

Figure 4 is a timing chart of operating the engine control device shown by Figure 3.

At first, the battery voltage 304 is applied to engine control device 107 through the input side power line 109a by using the check equipment (a screening test device) 108, and the constant voltage source circuitry 100 supplies a source voltage having the constant rated voltage (for example, 5V) in the usual time to the CPU 300 and the integrated circuit 112, 113 through the output side power line 109b so as to start to operate the CPU 300 and the integrated circuit 112, 113.

Next, when a high voltage switching designation is transmitted to the communication line 301a from the serial communication means 203 of the check equipment 108, the CPU 300 receives the high voltage switching designation signal 305 through the serial receiver circuit 301, and the high voltage switching designation signal 305 is output by the output voltage adjustment circuitry 303 so as to turn the transistor 204 on, and the output voltage value of the constant voltage source circuitry 100 is changed to be the high voltage value (7V, for example) for the screening.

In addition, the CPU 300 transmits a change over completion signal 307 to the communication line 302a through a serial transmitting circuit 302 and the signal 307 is returned to the check equipment 108.

Then, after having applied the high voltage in the predetermined time that is necessary for the screening, when the rated voltage switch over designation is transmitted to the communication line 301a from the serial communication circuitry 203 of the check equipment 108, the CPU 300 receives the rated voltage change over designation signal 306 through the serial receiver circuit 301, the rated voltage change over designation signal 306 is output to the output voltage adjustment circuitry 303, the transistor 204 is turned off, and the output voltage value of the constant voltage source circuitry 100 is changed to be the rated voltage (5V, for example).

In addition, the CPU 300 transmits the change over completion signal 308 to the communication line 302a through the serial transmitting circuit 302, and the signal 308 is returned to the check equipment 108.

Then, after the predetermined time has passed from the finishing of the screening, the characteristic of the device is tested by the check equipment 108, and the initial failures being potential defects of the integrated circuits 112, 113 are judged by checking the function of the engine control device 107.

As stated above, the embodiment configuration of the present invention has the following function based on the constitution mentioned above.

The engine control device 107 in the first embodiment configuration of the present invention comprises the CPU 111 to operate the program, integrated circuits 112, 113, the ROM to store the program, the constant voltage source circuitry 100 to output the rated voltage to the integrated circuits 112, 113 etc. and the output voltage adjustment circuitry 150 to switch the rated voltage in order to screen the integrated circuits 112, 113 mounted on the circuit board.

The output voltage adjustment circuitry 150 is connected to the other output voltage adjustment circuitry 150a so as to connect the resistors 101, 102, 106 with the electric switch 105, the resistors 101 and 102 being connected in series between the output side power line 110 of the rated voltage and the ground side. One end of the other resistor 106 is connected to the ground side andthe other end thereof is connected to the connecting point 103 of the resistors 101, 102, and the other resistor 106 is connected with the resistor 102 in parallel by turning the electric switch 105 on. The reference voltage source 104 of the constant voltage source circuitry 100 is connected with the connecting point 103 between the resistors 101, 102 through the non-used terminal A of the engine control device 107.

Therefore, the screening of all integrated circuits 112, 113 after being mounted can be performed at a time by changing the intermediate voltage of the connecting point 103 without providing a complicated circuitry and an outside output signal means especially. Thus, reduction of the manufacturing cost and shortening of the time of the screening can be achieved.

In the above configuration, further, the voltage value is changed for the screening, and a reduction of power consumption can be planned by using the change of this voltage value for engine control. In the engine control device 107 of the second embodiment configuration, the CPU 200 has a built-in the ROM (flash ROM) in which the program thereof is capable of being rewritten. The program of the CPU 200 is written in by the serial communication means 203, thereby the transistor 204 of the output voltage adjustment circuitry 250 is switched on or off so as to change the intermediate voltage of the connecting point 103, and in a case of an engine control device having a limited terminal and not having a non-used terminal A, the screening of the integrated circuits 112, 113 after mounting can be performed.

Furthermore, in the engine control device 107 of the third configuration, the CPU 300 has a built-in control program to mutually switch a program to set the output of the port 309 of the CPU 300 to be in the low level and a program to set the output of the port 309 to be in the high level, according to the output signal from the serial communication means 203. The programs of the CPU 300 are switched by the serial communication means 203, thereby the transistor 204 of the output voltage adjustment circuitry 303 is switched on or off and the intermediate voltage of the connecting point 103 can be changed. If the engine control device does not have a non-used terminal A and the CPU does not have the flash ROM, the screening of the integrated circuit 112, 113 after mounting can be performed.

Although the embodiment configuration of the present invention is explained in detail as above, the present invention is not limited to the above embodiment configuration, various kinds of modification are possible in design without deviating from the present invention as defined in the claims.

In the first embodiment configuration, the output voltage adjustment circuitry is divided into the engine control device and the check equipment.

In addition, the check equipment is not limited to be used for only the engine control device, and by providing the output voltage adjustment circuitry and the characteristic check circuit as the control device of the integrated circuit mounted in the bare chip state, the screening of the integrated circuit and the function test can be performed.

As being apparent from the above-mentioned description, the engine control device of the present invention can perform the screening of the semiconductor integrated circuit mounted in the bare chip state on the circuit board by arranging the output voltage adjustment circuit, and a reduction of the mounting area size and an improvement of the electrical characteristic nature becomes possible and reduction of the manufacturing cost can be planned too by a simple constitution thereof.

## Claims

1. A screening system for an engine control device (107) comprising an integrated circuit (111, 112, 113), such as an arithmetic processing unit etc., for processing operation of control programs, wherein said engine control device (107) comprises an output voltage adjustment circuitry (150) to switch a rated voltage to screen said integrated circuit (111, 112, 113),
said output voltage adjustment circuitry (150) comprises plural resistors (101, 102) provided between an output side power line (110) of said rated voltage and a ground side, and
another resistor (106) coupled to a connecting point (103) between said plural resistors (101, 102) and said ground side is provided,
**characterized in that**
said other resistor (106) is provided outside of said engine control device (107) and provided inside of a check equipment (108) coupled to said engine control device (107) through a connector when screening said integrated circuit (111, 112, 113), wherein the engine control device (107) and the check equipment (108) are separate modules.

2. An engine control device as defined in claim 1, said engine control device (107) being **characterized in that**
said other resistor (106) is coupled to said connecting point (103) between said plural resistors (101, 102) through a switch (105) provided inside of said check equipment (108).

3. An engine control device as defined in claim 2, said engine control device (107) being **characterized in that**
said other resistor (106) is coupled to said connecting point (103) between said plural resistors (101, 102) through a non-connected terminal of said engine control device (107).

4. An engine control device as defined in claims 1 to 3, said engine control device (107) being **characterized in that**
said engine control device (107) adds a higher voltage value than that in usual operation on said integrated circuit (111, 112, 113) when screening said integrated circuit (111, 112 , 113).

## Patentansprüche

1. Klassierungssystem für eine Motorsteuervorrichtung (107), die eine integrierte Schaltung (111, 112, 113) wie etwa eine Arithmetikverarbeitungseinheit usw. für die Verarbeitungsoperation von Steuerprogrammen umfasst, wobei die Motorsteuervorrichtung (107) eine Ausgangsspannung-Einstellschaltungsanordnung (150) umfasst, um eine Nennspannung umzuschalten, um die integrierte Schaltung (111, 112, 113) zu klassieren,
wobei die Ausgangsspannungs-Einstellschaltungsanordnung (150) mehrere ohmsche Widerstände (101, 102) umfasst, die zwischen einer ausgangsseitigen Leistungsleitung (110) für die Nennspannung und Masse vorgesehen sind, und ein weiterer ohmscher Widerstand (106), der mit einem Verbindungspunkt (103) zwischen den mehreren ohmschen Widerständen (101, 102) und Masse gekoppelt ist, vorgesehen ist,
**dadurch gekennzeichnet, dass**
der weitere ohmsche Widerstand (106) außerhalb der Motorsteuervorrichtung (107) vorgesehen ist und in einer Prüfanordnung (108) vorgesehen ist, die mit der Motorsteuervorrichtung (107) über einen Verbinder gekoppelt ist, wenn die integrierte Schaltung (111, 112, 113) klassiert wird, wobei die Motorsteuervorrichtung (107) und die Prüfanordnung (108) getrennte Module sind.

2. Motorsteuervorrichtung nach Anspruch 1, wobei die Motorsteuervorrichtung (107) **dadurch gekennzeichnet ist, dass**
der weitere ohmsche Widerstand (106) mit dem Verbindungspunkt (103) zwischen den mehreren ohmschen Widerständen (101, 102) über einen Schalter (105), der in der Prüfanordnung (108) vorgesehen ist, gekoppelt ist.

3. Motorsteuervorrichtung nach Anspruch 2, wobei die Motorsteuervorrichtung (107) **dadurch gekennzeichnet ist, dass**
der weitere ohmsche Widerstand (106) mit dem Verbindungspunkt (103) zwischen den mehreren ohmschen Widerständen (101, 102) über einen nicht verbundenen Anschluss der Motorsteuervorrichtung (107) gekoppelt ist.

4. Motorsteuervorrichtung nach den Ansprüchen 1 bis 3, wobei die Motorsteuervorrichtung (107) **dadurch gekennzeichnet ist, dass**
die Motorsteuervorrichtung (107) eine Spannung mit höherem Wert als jener im Normalbetrieb der integrierten Schaltung (111, 112, 113) anlegt, wenn die integrierte Schaltung (111, 112, 113) klassiert wird.

## Revendications

1. Système de sélection pour un dispositif de régulation (107) de moteur à combustion interne comprenant un circuit intégré (111, 112, 113), tel qu'une unité centrale de calcul etc., pour exécuter des programmes de régulation, dans lequel ledit dispositif de régulation (107) de moteur à combustion interne comporte un circuit de réglage de la tension de sortie (150) destiné à commuter une tension nominale pour sélectionner ledit circuit intégré (111, 112, 113),
ledit circuit de réglage de la tension de sortie (150) comporte une pluralité de résistances (101, 102) disposées entre un secteur électrique côté sortie (110) de ladite tension nominale et le côté de mise à la masse, et une autre résistance (106) couplée à un point de connexion (103) entre ladite pluralité de résistances (101, 102) et ledit côté de mise à la masse est prévue,
**caractérisé en ce que**
ladite autre résistance (106) est disposée à l'extérieur dudit dispositif de régulation (107) de moteur à combustion interne et montée à l'intérieur d'un équipement de contrôle (108) couplé audit dispositif de régulation (107) de moteur à combustion interne par l'intermédiaire d'un connecteur lors de la sélection dudit circuit intégré (111, 112, 113), le dispositif de régulation (107) de moteur à combustion interne et l'équipement de contrôle (108) se présentant en l'occurrence sous la forme de modules séparés.

2. Dispositif de régulation de moteur à combustion interne tel qu'il est défini dans la revendication 1, ledit dispositif de régulation (107) de moteur à combustion interne étant **caractérisé en ce que**
ladite autre résistance (106) est couplée audit point de connexion (103) entre ladite pluralité de résistances (101, 102) par l'intermédiaire d'un commutateur (105) disposé à l'intérieur dudit équipement de contrôle (108).

3. Dispositif de régulation de moteur à combustion interne tel qu'il est défini dans la revendication 2, ledit dispositif de régulation (107) de moteur à combustion interne étant **caractérisé en ce que**
ladite autre résistance (106) est couplée audit point de connexion (103) entre ladite pluralité de résistances (101, 102) par l'intermédiaire d'une connexion non connectée dudit dispositif de régulation (107) de moteur à combustion interne.

4. Dispositif de régulation de moteur à combustion interne tel qu'il est défini dans les revendications 1 à 3, ledit dispositif de régulation (107) de moteur à combustion interne étant **caractérisé en ce que**
ledit dispositif de régulation (107) de moteur à combustion interne ajoute une valeur de tension supérieure à celle usitée dans le fonctionnement habituel dudit circuit intégré (111, 112, 113) lors de la sélection dudit circuit intégré (111, 112, 113).
